# FASCICULE DE BREVET EUROPEEN

(11) **EP 3 987 893 B1**
(45) Date de publication et mention de la délivrance du brevet: **03.07.2024**
(21) Numéro de dépôt: 20730430.4
(22) Date de dépôt: 09.06.2020
(51) Int. Cl.: H05K 7/14

(54) **SYSTEME ELECTRONIQUE AVEC DISPOSITIF ELECTRONIQUE DE MESURE ET COMPORTANT UNE ETANCHEITE ET ENSEMBLE ELECTRIQUE COMPRENANT UN TEL SYSTEME ELECTRONIQUE**
ELEKTRONISCHES SYSTEM MIT ELEKTRONISCHER MESSVORRICHTUNG UND MIT EINER DICHTUNG UND ELEKTRISCHE BAUGRUPPE MIT SOLCH EINEM ELEKTRONISCHEN SYSTEM
ELECTRONIC SYSTEM WITH ELECTRONIC MEASURING DEVICE AND COMPRISING A SEAL AND AN ELECTRICAL ASSEMBLY INCLUDING SUCH AN ELECTRONIC SYSTEM

(30) Priorité: 21.06.2019 FR 1906760
(43) Date de publication de la demande: 27.04.2022
(73) Titulaire: VALEO EQUIPEMENTS ELECTRIQUES MOTEUR, 94046 Créteil Cedex (FR)
(72) Inventeur: SCHEITEL, Frédéric, 94046 CRETEIL CEDEX (FR); DUMEZ, Charles, 94046 CRETEIL CEDEX (FR); FALGUIER, Manuel, 94046 CRETEIL CEDEX (FR); SANCHES, Michaël, 94046 CRETEIL CEDEX (FR)
(74) Mandataire: Valeo Powertrain Systems
(86) Numéro de dépôt international: PCT/EP2020/065958
(87) Numéro de publication internationale: WO 2020/254150

(56) Documents cités:
- FR-A1- 3 068 564
- JP-A- 2006 092 776
- JP-A- 2007 166 803
- US-A- 5 623 399

## Description

L'invention porte sur un système électronique, notamment un système électronique de contrôle pour machine électrique tournante, comprenant un dispositif de mesure et comportant une étanchéité et un ensemble électrique comprenant un tel système électronique et une machine électrique tournante.

De manière connue un système électronique peut comprendre :
- un module électronique de puissance permettant la conversion d'un courant continu à un courant alternatif, le module électronique de puissance comprenant :
- une première barre omnibus et une deuxième barre omnibus permettant une alimentation du module électronique de puissance avec le courant continu,
- une troisième barre omnibus apte à alimenter un bobinage de phase d'une machine électrique tournante,
- une broche de commande recevant un signal de commande permettant de piloter le module électronique de puissance
- un module électronique de commande distinct du module électronique de puissance et configuré pour générer le signal de commande, le module électronique de commande comprenant un dispositif électronique de mesure,
- un support portant le module électronique de commande sur un premier côté du support, le support comprenant une excroissance d'un deuxième côté du support opposé au premier côté du support,
- un boitier de mesure comprenant une encoche, le boitier étant situé du deuxième côté du support, le dispositif électronique de mesure étant logé dans l'excroissance du support,
l'excroissance pénétrant dans la cavité du boitier de mesure de manière à ce que le dispositif électronique de mesure pénètre aussi dans l'encoche du boitier de mesure.

L'encoche du boitier de mesure peut correspondre à un entrefer d'un tore magnétique compris dans le boitier de mesure. Le document FR3068564 A1 présente un exemple de boitier de mesure avec un tore magnétique. Dans ce document le boitier de mesure est surmoulé sur le tore magnétique.

Le dispositif électronique de mesure est par exemple un capteur à effet Hall. Un tel capteur à effet Hall pénétrant dans l'entrefer du tore magnétique permet de mesurer le courant passant dans un conducteur traversant le tore magnétique.

Dans ce type de système électronique il est important de protéger le module électronique de commande par exemple avec un gel ou une résine de protection. Il est connu d'utiliser un support qui définit un logement avec une paroi de fond dans laquelle est formée l'excroissance, le module électronique de commande étant logé dans le logement. Grâce l'étanchéité de l'excroissance, il est possible de remplir le logement de manière à recouvrir le module électronique de commande d'un gel ou d'une résine de protection.

Une telle mesure de courant est possible si le support et son excroissance sont réalisés dans une matière plastique.

Pour des raisons de résistance mécanique et/ou de propriétés thermiques et/ou de protection au feu, on peut préférer l'utilisation d'un support en métal. Cependant l'utilisation d'un support avec une excroissance métallique rend la mesure difficile. En effet des courant de Foucault sont induits à haute fréquence dans le métal du support et son excroissance. Ces courants de Foucault induisent des perturbations dans la mesure.

La présente invention vise à résoudre tout ou partie de ces inconvénients.

L'invention porte sur un système électronique comprenant :
- un module électronique de puissance permettant la conversion d'un courant continu à un courant alternatif, le module électronique de puissance comprenant :
- une première barre omnibus et une deuxième barre omnibus permettant une alimentation du module électronique de puissance avec le courant continu,
- une troisième barre omnibus apte à alimenter un bobinage de phase d'une machine électrique tournante,
- une broche de commande recevant un signal de commande permettant de piloter le module électronique de puissance,
- un module électronique de commande distinct du module électronique de puissance et configuré pour générer le signal de commande, le module électronique de commande comprenant un dispositif électronique de mesure,
- un support comprenant une ouverture et portant le module électronique de commande sur un premier côté du support, le support étant en métal,
- un boitier de mesure comprenant une cavité, le boitier de mesure étant situé d'un deuxième côté du support opposé au premier côté du support,

le dispositif électronique de mesure pénétrant dans l'ouverture du support et dans la cavité du boitier de mesure,
un moyen d'étanchéité assurant une étanchéité entre le boitier de mesure et le support.

Un tel système permet d'une part l'utilisation d'un dispositif électronique de mesure d'un module électronique de commande porté par un support en réduisant les perturbations que pourrait engendrer le support, notamment si le support est métallique. En effet l'ouverture du support laisse passer une partie sensible du dispositif électronique de mesure en sorte que le support n'interfère pas entre la partie sensible et un élément avec lequel la partie sensible interagit. Il est ainsi possible d'utiliser un dispositif de mesure dont la partie sensible est un capteur à effet Hall sur un support métallique par exemple en aluminium. Un tel capteur est par exemple utilisé pour mesurer le courant passant dans un conducteur traversant un tore magnétique avec un entrefer. Le capteur à effet Hall est alors placé dans l'entrefer. L'absence de partie métallique entre le tore magnétique et le capteur à effet Hall permet d'éviter les perturbations dans la mesure qui seraient générées par des courants de Foucault qui seraient induits à haute fréquence dans une telle partie métallique.

Le moyen d'étanchéité entre le boitier de mesure et le support permet par exemple l'utilisation d'un moyen de protection tel un gel de protection pour le module électronique de commande dans le support malgré la présence des ouvertures dans le support.

Selon une caractéristique supplémentaire de l'invention le module électronique de puissance comprend une première boite surmoulée sur la première barre omnibus, la deuxième barre omnibus, la troisième barre omnibus et la broche de commande, et le boitier de mesure est formé en continuité de matière avec la première boite surmoulée du module électronique de puissance.

Selon une première variante de l'invention, le boitier de mesure comprend une cheminée, comprenant une première extrémité libre, entourant une extrémité ouverte de la cavité et le support comprend une gorge en regard de la première extrémité libre de la cheminée du boitier de mesure.

Selon une deuxième variante de l'invention, le support comprend une cheminée, comprenant une première extrémité libre, entourant l'ouverture du support du deuxième côté du support et le boitier de mesure comprend une gorge en regard de la première extrémité libre de la cheminée.

Selon une caractéristique supplémentaire de l'invention, un joint inséré dans la gorge assure l'étanchéité entre le boitier de mesure et le support.

Selon une caractéristique supplémentaire de l'invention, le joint est un dépôt de colle.

L'utilisation d'une gorge permet de faciliter l'application du joint sur le support dans la première variante de l'invention et sur le boitier dans la deuxième variante de l'invention. Lors de la manipulation des pièces, la gorge limite le déplacement d'un joint solide tel un joint en élastomère, ou limite l'écoulement d'un joint fluide tel une colle.

Selon une troisième variante de l'invention :
- soit le boitier de mesure comprend une cheminée, comprenant une première extrémité libre d'une première forme, entourant une extrémité ouverte de la cavité et le support comprend une surface d'appui d'une deuxième forme, complémentaire de la première forme en regard de la première extrémité libre de la cheminée du boitier de mesure,
- soit le support comprend une cheminée, comprenant une première extrémité libre d'une première forme, entourant l'ouverture du support du deuxième côté du support et le boitier de mesure comprend une face d'appui d'une deuxième forme, complémentaire de la première forme en regard de la première extrémité libre de la cheminée du support,
- soit le support comprend une première cheminée, comprenant une première extrémité libre d'une première forme, entourant l'ouverture du support du deuxième côté du support et le boitier de mesure comprend une deuxième cheminée, comprenant une deuxième extrémité libre d'une deuxième forme complémentaire de la première forme, entourant une extrémité ouverte de la cavité, la deuxième extrémité libre de la deuxième cheminée du boitier de mesure étant en regard de la première extrémité libre de la première cheminée du support,
un joint étant disposé entre la première forme du support et la deuxième forme du boitier de mesure.

L'utilisation de formes complémentaires entre le support et le boitier de mesure permet l'utilisation de joints plat simple ou de joint en pâte en faible quantité. Il est ainsi possible de réduire le coût du système électronique.

Selon une quatrième variante de l'invention, le support comprend une première excroissance tubulaire entourant l'ouverture du support du deuxième côté du support et le boitier de mesure comprend une deuxième excroissance tubulaire au moins partiellement autour de la cavité, la première excroissance tubulaire pénétrant dans la deuxième excroissance tubulaire.

Selon une caractéristique supplémentaire de la quatrième variante de l'invention, un dispositif d'étanchéité est disposé entre la première excroissance tubulaire et la deuxième excroissance tubulaire. Selon une caractéristique supplémentaire de la quatrième variante de l'invention, le dispositif d'étanchéité est une résine versée dans la cavité puis polymérisée.

L'utilisation d'une résine pour assurer l'étanchéité entre le support et le boitier de mesure permet des tolérances dimensionnelles plus large sur les zones entre lesquelles l'étanchéité est réalisée. En effet la fluidité de la résine avant sa polymérisation permet une bonne adaptation aux des pièces en contact avec la résine. Il est donc possible d'avoir des tolérances larges sur les dimensions de la première excroissance tubulaire et de la deuxième excroissance tubulaire. On peut ainsi réduire le coût du système électronique.

Selon une caractéristique supplémentaire de l'invention, le boitier de mesure comprend un tore magnétique présentant un entrefer et le dispositif électronique de mesure comprend un capteur à effet hall inséré dans la cavité du boitier de mesure et l'entrefer, le tore magnétique et le capteur à effet hall coopérant pour mesurer le courant d'un conducteur électrique traversant le tore magnétique.

Selon une caractéristique supplémentaire de l'invention, le conducteur électrique est connecté électriquement à la troisième barre omnibus.

Selon une caractéristique supplémentaire de l'invention, le boitier de mesure est surmoulé sur le conducteur électrique et/ou le boitier de mesure est surmoulé sur le tore magnétique.

Selon une caractéristique supplémentaire de l'invention, le support défini un logement avec une paroi de fond dans laquelle est ménagée l'ouverture, le module électronique de commande est logé dans le logement et un gel ou une résine de protection remplit le logement de manière à recouvrir le module électronique de commande.

L'invention porte également sur un ensemble électrique comprenant :
- un système électronique tel que décrit précédemment,
- une machine électrique tournante.

L'invention pourra être mieux comprise à la lecture de la description qui va suivre d'exemples non limitatifs de mise en oeuvre de celle-ci et à l'examen du dessin annexé sur lequel :
- [Fig.1] la figure 1 représente un schéma électrique d'un ensemble électrique comportant un système électronique selon l'invention,
- [Fig.2] la figure 2 représente une vue schématique partielle éclatée d'un système électronique selon l'invention,
- [Fig.3] la figure 3 représente une vue d'un boitier de mesure utilisé dans le système électronique de la figure 2,
- [Fig.4] la figure 4 représente une vue partielle du boitier de mesure de la figure 3,
- [Fig.5] la figure 5 représente une vue partielle en coupe d'un système électronique selon un premier mode de réalisation de l'invention,
- [Fig.6] la figure 6 représente une vue partielle en coupe d'un système électronique selon un deuxième mode de réalisation de l'invention,
- [Fig.7] la figure 7 représente une première étape d'assemblage du module électronique de la figure 5,
- [Fig.8] la figure 8 représente une deuxième étape d'assemblage du module électronique de la figure 5,
- [Fig.9] la figure 9 représente une troisième étape d'assemblage du module électronique de la figure 5,
- [Fig.10] la figure 10 représente une première étape d'assemblage du module électronique de la figure 6,
- [Fig.11] la figure 11 représente une deuxième étape d'assemblage du module électronique de la figure 6,
- [Fig.12] la figure 12 représente un troisième étape d'assemblage du module électronique de la figure 6.

Sur toutes les figures, les éléments identiques ou assurant la même fonction portent les mêmes numéros de référence. Les réalisations suivantes sont des exemples. Bien que la description se réfère à un ou plusieurs modes de réalisation, ceci ne signifie pas nécessairement que chaque référence concerne le même mode de réalisation ou que les caractéristiques s'appliquent seulement à un seul mode de réalisation. De simples caractéristiques de différents modes de réalisation peuvent également être combinées ou interchangées pour fournir d'autres réalisations.

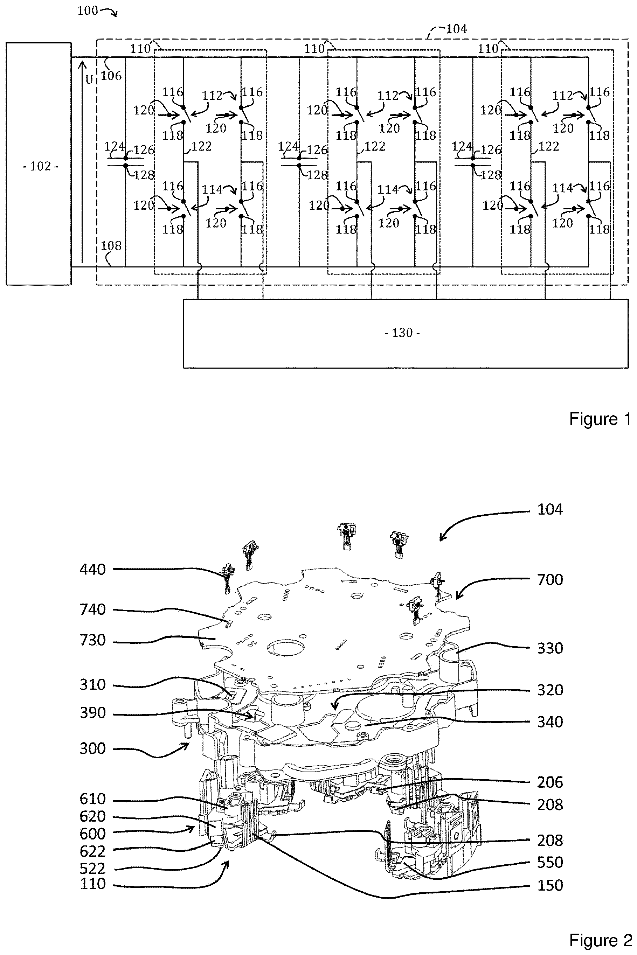

La figure 1 représente un ensemble électrique 100 dans lequel peut être mis en oeuvre l'invention.

L'ensemble électrique 100 est par exemple destiné à être implanté dans un véhicule automobile.

L'ensemble électrique 100 comporte tout d'abord une source d'alimentation électrique 102 conçue pour fournir une tension continue U, par exemple comprise entre 20 V et 100 V, par exemple 48 V. La source d'alimentation électrique 102 comporte par exemple une batterie.

L'ensemble électrique 100 comporte en outre une machine électrique tournante 130 comportant plusieurs enroulements de phase (non représentés) destinés à présenter des tensions de phase respectives. L'ensemble électrique 100 comporte en outre un système électronique 104.

Dans les différents modes de réalisation représentés sur les figures le système électronique 104 est un convertisseur de tension 104. Cependant dans d'autres modes de réalisation non représentés l'ensemble peut assurer une fonction différente.

Le convertisseur de tension 104 est connecté entre la source d'alimentation électrique 102 et la machine électrique 130 pour effectuer une conversion entre la tension continue U et les tensions de phase.

Le convertisseur de tension 104 comporte tout d'abord une ligne électrique positive 106 et une ligne électrique négative 108 destinées à être connectées à la source d'alimentation électrique 102 pour recevoir la tension continue U, la ligne électrique positive 106 recevant un potentiel électrique haut et la ligne électrique négative 108 recevant un potentiel électrique bas. La ligne électrique négative reçoit par exemple un potentiel nul et est connecté à une masse du véhicule automobile.

Le convertisseur de tension 104 comporte en outre au moins un module électronique de puissance 110 comportant une ou plusieurs lignes électriques de phase 122 destinées être respectivement connectées à une ou plusieurs phases de la machine électrique 130, pour fournir leurs tensions de phase respectives. Dans l'exemple décrit, le convertisseur de tension 104 comporte trois modules électroniques de puissance 110 comportant chacun deux lignes électriques de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières lignes électriques de phase 122 des modules électroniques de puissance 110 sont respectivement connectées aux trois phases du premier système triphasé, tandis que les deuxièmes lignes électriques de phase 122 des modules électroniques de puissance 110 sont respectivement connectées aux trois phases du deuxième système triphasé.

Chaque module électronique de puissance 110 comporte, pour chaque ligne électrique de phase 122, un premier interrupteur commandable 112 connecté entre la ligne électrique positive 106 et la ligne électrique de phase 122 et un deuxième interrupteur commandable 114 connecté entre la ligne électrique de phase 122 et la ligne électrique négative 108. Ainsi, les interrupteurs commandables 112, 114 sont agencés de manière à former un bras de hachage, dans lequel la ligne électrique de phase 122 forme un point milieu.

Chaque interrupteur commandable 112, 114 comporte des première et deuxième bornes principales 116, 118 et une borne de commande 120 destinée à sélectivement ouvrir et fermer l'interrupteur commandable 112, 114 entre ses deux bornes principales 116, 118 en fonction d'un signal de commande qui lui est appliqué. Les interrupteurs commandables 112, 114 sont de préférence des transistors, par exemple des transistors à effet de champ à structure métal-oxyde-semiconducteur (de l'anglais « Métal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs commandables 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une face de dissipation de chaleur.

Le convertisseur de tension 104 comporte en outre, pour chaque module électronique de puissance 110, une capacité de filtrage 124 présentant une première borne 126 et une deuxième borne 128 respectivement connectées à la ligne électrique positive 106 et à la ligne électrique négative 108.

Il sera apprécié que la ligne électrique positive 106, la ligne électrique négative 108 et les lignes électriques de phase 122 sont des éléments rigides conçus pour supporter des courants électriques d'au moins 1 A. Elles présentent de préférence une épaisseur d'au moins 1 mm.

En outre, dans l'exemple décrit, la machine électrique 130 a à la fois une fonction d'alternateur et de moteur électrique. Plus précisément, le véhicule automobile comporte en outre un moteur thermique (non représenté) présentant un axe de sortie auquel la machine électrique 130 est reliée par exemple par une courroie ou par une chaine ou par un train d'engrenages (non représentée). Le moteur thermique est destiné à entraîner des roues du véhicule automobile par l'intermédiaire de son axe de sortie. Ainsi, en fonctionnement comme alternateur, la machine électrique fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

La figure 2 représente un système électronique 104 selon l'invention.

Le système électronique 104 comprend :
- un module électronique de puissance 110 permettant la conversion d'un courant continu à un courant alternatif, le module électronique de puissance 110 comprenant :
- une première barre omnibus 206 et une deuxième barre omnibus 208 permettant une alimentation du module électronique de puissance 110 avec le courant continu,
- une troisième barre omnibus 522 apte à alimenter un bobinage de phase de la machine électrique tournante 130,
- une broche de commande 520 recevant un signal de commande permettant de piloter le module électronique de puissance 110.

La première barre omnibus 206 est connectée électriquement à la ligne électrique positive 106. La deuxième barre omnibus 208 est connectée électriquement à la ligne électrique négative 108. La troisième barre omnibus 522 est connectée électriquement à la ligne électrique de phase 122. La broche de commande 150 est connecté électriquement à la borne de commande 120.

Le module électronique de puissance 110 peut comprendre en outre une première boite surmoulée 550 sur le premier interrupteur commandable 112, le deuxième interrupteur commandable 114, la première barre omnibus 206, la deuxième barre omnibus 208, la troisième barre omnibus 522 et la broche de commande 150. Le module électronique de puissance est par exemple réalisé avec une technologie de type TML (en anglais Transfer Molded Leadframe soit en français barre bus moulé par transfert). L'isolant électrique est par exemple une résine thermodurcissable de type époxy.

Dans un autre mode de réalisation non représenté, le module électronique de puissance comprend en outre une première boite surmoulée sur la première barre omnibus, la deuxième barre omnibus, la troisième barre omnibus et la broche de commande. Le premier interrupteur commandable et le deuxième interrupteur commandable sont connectés électriquement à la première barre omnibus, la deuxième barre omnibus, la troisième barre omnibus et la broche de commande mais ne sont pas surmoulées dans la première boite. Par exemple un gel de protection est déposé dans la boite pour protéger le premier interrupteur commandable et le deuxième interrupteur commandable ainsi que leur connexions à la première barre omnibus, à la deuxième barre omnibus et à la broche de commande.

Le système électronique 104 peut comprendre en outre un dissipateur thermique (non représenté).

Le module électronique de puissance 110 est fixé sur le dissipateur thermique à l'aide d'un moyen de fixation.

Le module électronique de puissance 110 comprend une surface de dissipation thermique. Cette surface de dissipation thermique est en contact thermique avec une surface d'échange thermique du dissipateur thermique. Le contact thermique est par exemple réalisé grâce à une pâte thermique ou une colle thermique.

Le système électronique comprend en outre :
- un module électronique de commande 700 distinct du module électronique de puissance et configuré pour générer le signal de commande, le module électronique de commande 700 comprenant un dispositif électronique de mesure 440,
- un support 300 comprenant une ouverture 310 et portant le module électronique de commande 700 sur un premier côté 320 du support 300,
- un boitier de mesure 600 comprenant une cavité 640, le boitier de mesure 600 étant situé d'un deuxième côté 360 du support 300 opposé au premier côté 320 du support 300.

Le dispositif électronique de mesure 440 pénètre dans l'ouverture 310 du support 300 et dans la cavité 640 du boitier de mesure 600.

Le support 300 est par exemple en métal, notamment un alliage d'aluminium.

Le support 300 défini un logement 390 avec une paroi de fond 340 et un rebord 330. Le module électronique de commande 700 est logé dans le logement 390. La paroi de fond 340 est par exemple globalement plate. Le rebord 330 a par exemple une forme globalement tubulaire se projetant à partir de la paroi de fond 340 du côté du module électronique de commande 700.

Le module électronique de commande 700 comprend par exemple une carte électronique 730 et des composants électroniques connectés à la carte électronique 730. Le dispositif électronique de mesure 440 est par exemple connecté à la carte électronique 730 et est fixé à la carte électronique 730dans des trous 740, par exemple de forme oblongue, formés dans la carte électronique 730.

Le module électronique de commande 700 peut comprendre une surface de dissipation thermique. Cette surface de dissipation thermique est en contact thermique avec une surface d'échange thermique du support 300, par exemple une surface d'échange thermique de la paroi de fond 340. Le contact thermique est par exemple réalisé grâce à une pâte thermique ou une colle thermique.

L'utilisation d'un support 300 en métal permet d'améliorer le refroidissement du module électronique de commande 700.

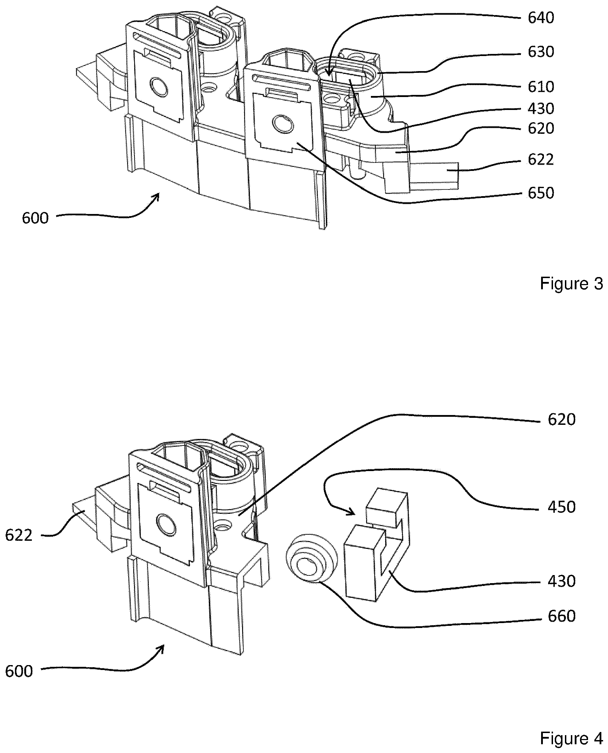

La figure 3 et la figure 4 représente le boitier de mesure 600.

Dans le mode de réalisation représenté, le boitier de mesure 600 est un module d'interconnexion. Il assure la connexion électrique entre la troisième barre omnibus 522 et le bobinage de phase de la machine électrique 130. Le boitier de mesure 600 comprend un conducteur 622. Le conducteur 622 est connecté par exemple à une de ces extrémités à la troisième barre omnibus 522 et à une autre de ces extrémités au bobinage de phase de la machine 130.

Le boitier de mesure 600 représenté sur la figure 3 et la figure 4 comprend deux conducteurs 622 pour connecter deux troisièmes barres omnibus 522 à deux bobinages de phase de la machine électrique 130. Chacun des deux conducteurs 622 étant connecté à une troisième barre omnibus et apte à être connecté à un bobinage de phase de la machine 130.

La connexion entre le conducteur 622 et la troisième barre omnibus 522 est par exemple réalisée par soudure telle une soudure électrique, une soudure laser ou un brasage.

La connexion entre le conducteur 622 et le bobinage de phase est par exemple réalisée par vissage. Pour améliorer la connexion par vissage, un écrou 660 peut être fixé, par exemple par soudage ou emmanchement à force, au conducteur 622.

Le boitier de mesure 600 peut comprendre en outre un tore magnétique 430. Le conducteur électrique 622 traverse le tore magnétique 430. Le dispositif électronique de mesure 440 peut comprendre un capteur à effet hall 460. Le tore magnétique 430 présente un entrefer 450. La cavité 640 du boitier de mesure 600 pénètre dans l'entrefer 450. Le capteur à effet Hall 460 du dispositif de mesure 440 est inséré dans la cavité 640 du boitier de mesure 600. Le tore magnétique 430 et le capteur à effet Hall coopère pour mesurer le courant dans le conducteur électrique 622.

Le boitier de mesure 600 comprend une deuxième boite surmoulée 620 sur le conducteur électrique 622 et le tore 430.

Dans un autre mode de réalisation non représenté, le boitier de mesure est formé dans le module électronique de puissance. Une des barres omnibus du module électronique de puissance, notamment la troisième barre omnibus, traverse le tore magnétique. Dans ce mode de réalisation il y a continuité de matière entre le module électronique de puissance et le boitier de mesure. Par exemple la première boite surmoulée 550 et la deuxième boite surmoulée 620 forment une seule et même boite.

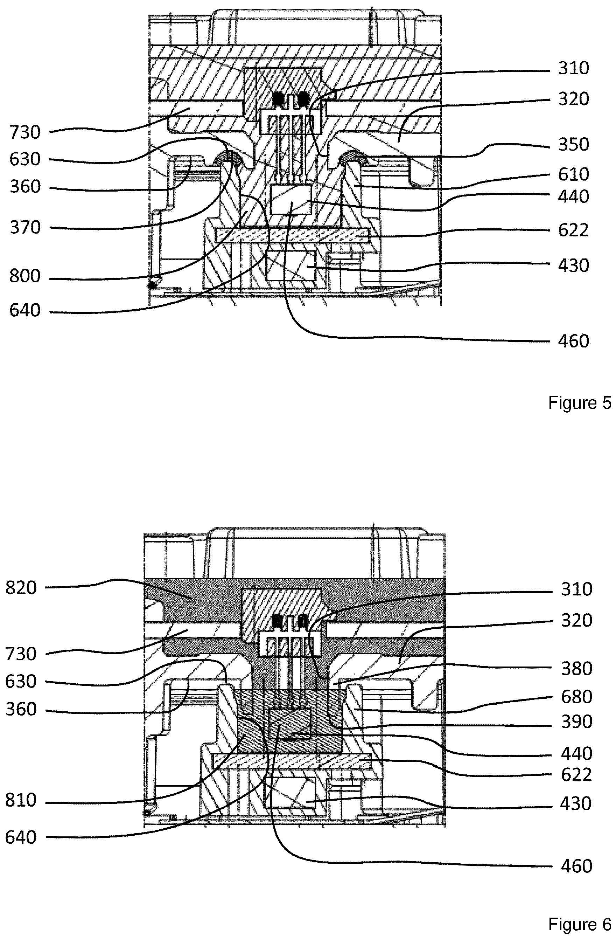

La figure 5 représente un premier mode de réalisation de l'invention.

Dans ce mode de réalisation, le boitier de mesure 600 comprend une cheminée 610, comprenant une première extrémité libre 630. La cheminée 610 entoure une extrémité ouverte de la cavité 640. Le support 300 comprend une gorge 370 en regard de la première extrémité libre 630 de la cheminée 610 du boitier de mesure 600.

Un moyen d'étanchéité assure une étanchéité entre le boitier de mesure 600 et le support 300. Le moyen d'étanchéité est par exemple un joint 350 inséré dans la gorge 370. Le joint est par exemple un dépôt de colle.

Un moyen de protection 800, notamment un gel ou une résine de protection par exemple polymérisable remplit le logement 390 de manière à recouvrir le module électronique de commande 700.

Le moyen de protection 800 remplit également l'ouverture 310 du support et la cavité 640 du boitier de mesure 600.

On entend par le terme remplir que le moyen de protection 800 empêche l'intrusion de liquide ou autre éléments polluants sur le module électronique de commande 700 et en particulier sur le dispositif électronique de mesure 440. Il peut être acceptable que certaines zones du logement 390 de l'ouverture 310 et de la cavité 640 ne contiennent pas de moyen de protection. Ces zones, telles des bulles, peuvent être générée lors du remplissage du logement 390, de l'ouverture 310 et de la cavité 640.

Le moyen d'étanchéité empêche le moyen de protection 800 de s'écouler entre le boitier de mesure 600 et le support 300.

Dans un autre mode de réalisation de l'invention non représenté, le support comprend une cheminée, comprenant une première extrémité libre. La cheminée entoure l'ouverture du support du deuxième côté du support et le boitier de mesure comprend une gorge en regard de la première extrémité libre de la cheminée. Comme dans le premier mode de réalisation, le moyen d'étanchéité entre le boitier de mesure et le support est par exemple un j oint, notamment un dépôt de colle, inséré dans la gorge.

Dans un autre mode de réalisation non représenté, le boitier de mesure comprend une cheminée comprenant une première extrémité libre d'une première forme. La cheminée entoure une extrémité ouverte de la cavité. Le support comprend une surface d'appui d'une deuxième forme, complémentaire de la première forme en regard de la première extrémité libre de la cheminée du boitier de mesure. La première forme de la première extrémité libre de la cheminée est en appui contre la deuxième forme de la surface d'appui du support directement ou par l'intermédiaire d'un joint disposé entre la première extrémité libre et la surface d'appui. Un tel joint est par exemple un dépôt de colle. La première forme et la deuxième forme sont par exemple des plans.

Dans un autre mode de réalisation non représenté, le support comprend une cheminée comprenant une première extrémité libre d'une première forme. La cheminée entoure l'ouverture du support du deuxième côté du support. Le boitier de mesure comprend une face d'appui d'une deuxième forme, complémentaire de la première forme en regard de la première extrémité libre de la cheminée du support. La première forme de la première extrémité libre du support est en appui contre la deuxième forme de la face d'appui du boitier de mesure directement ou par l'intermédiaire d'un joint disposé entre la première extrémité libre et la surface d'appui.

Dans un autre mode de réalisation non représenté, le support comprend une première cheminée, comprenant une première extrémité libre d'une première forme. La première cheminée entoure l'ouverture du support du deuxième côté du support. Le boitier de mesure comprend une deuxième cheminée, comprenant une deuxième extrémité libre d'une deuxième forme complémentaire de la première forme. La deuxième cheminée entoure une extrémité ouverte de la cavité. La deuxième extrémité libre de la deuxième cheminée du boitier de mesure est en regard de la première extrémité libre de la première cheminée du support. La première forme de la première cheminée du support est en appui contre la deuxième forme de la deuxième cheminée du boitier de mesure directement ou par l'intermédiaire d'un joint disposé entre la première forme de la première cheminée du support et la deuxième forme de la deuxième cheminée du boitier de mesure.

La figure 6 représente un deuxième mode de réalisation de l'invention.

Dans ce mode de réalisation, le support 300 comprend une première excroissance tubulaire 380 entourant l'ouverture 310 du support 300 du deuxième côté 360 du support 300. La première excroissance tubulaire 380 comprend une deuxième extrémité libre 390. Le boitier de mesure 600 comprend une deuxième excroissance tubulaire 680 au moins partiellement autour de la cavité 640. La première excroissance tubulaire 380 pénètre dans la deuxième excroissance tubulaire 680. Un dispositif d'étanchéité est disposé entre la première excroissance tubulaire 380 et la deuxième excroissance tubulaire 680.

Le dispositif d'étanchéité est, par exemple, une résine 810 versée dans la cavité 640 puis polymérisée. La quantité de résine 810 est suffisante en sorte que la deuxième extrémité libre 390 est immergée dans la résine.

La deuxième extrémité libre 390 est par exemple immergée dans la résine 810 de 0,5 mm à 10 mm et de préférence de 1 mm à 2 mm.

Le capteur à effet Hall 460 est immergé dans la résine 810.

Le capteur à effet Hall 460 dépasse par exemple hors de la première excroissance tubulaire 380 pour éviter les perturbations de la mesure du capteur Hall 460 par la première excroissance tubulaire 380.

Dans un autre mode de réalisation non représenté similaire au deuxième mode de réalisation, l'étanchéité n'est pas assurée par une résine polymérisée dans la cavité 640 mais par un joint disposé entre la première excroissance tubulaire 380 et la deuxième excroissance tubulaire 680. Le joint est par exemple un manchon élastique inséré dans la deuxième excroissance tubulaire 680 ou un manchon élastique disposé à l'extérieur de la première excroissance tubulaire 380.

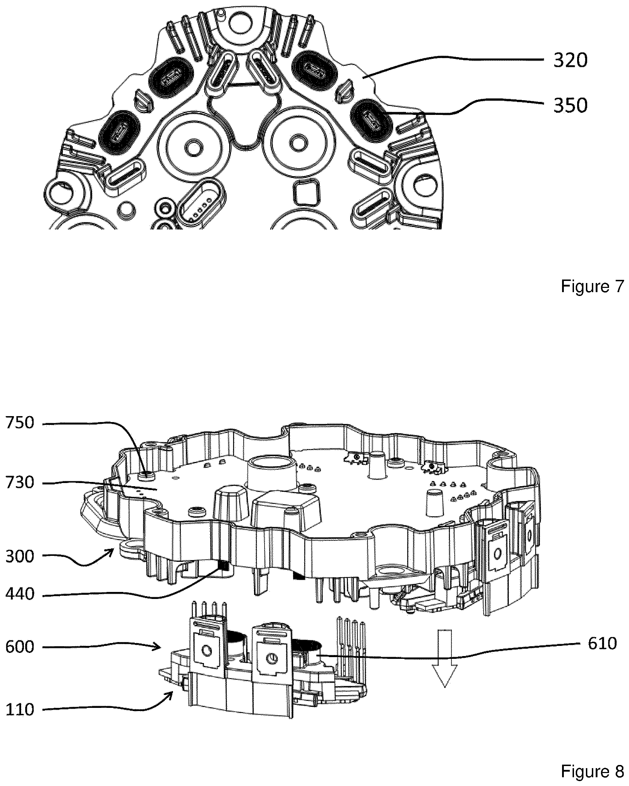

La figure 7, la figure 8 et la figure 9 représentent des étapes d'assemblage du système électronique 104 selon le premier mode de réalisation.

La figure 7 représente une première étape d'assemblage au cours de laquelle on dépose le joint 350 dans la gorge 370 du support 300.

Le joint 350 est par exemple posé dans la gorge 370 ou est déposé sous la forme d'une pâte à l'aide d'une buse (non représentée).

La figure 8 représente une deuxième étape d'assemblage au cours de laquelle on assemble le boitier de mesure 600 et le support 300, le module électronique de commande 700 ayant été monté dans le logement 390 du support 300.

A la fin de cette étape le joint 350 assure l'étanchéité entre la première extrémité libre 630 de la cheminée 610 du boitier de mesure 600 et la gorge 370 du support 300.

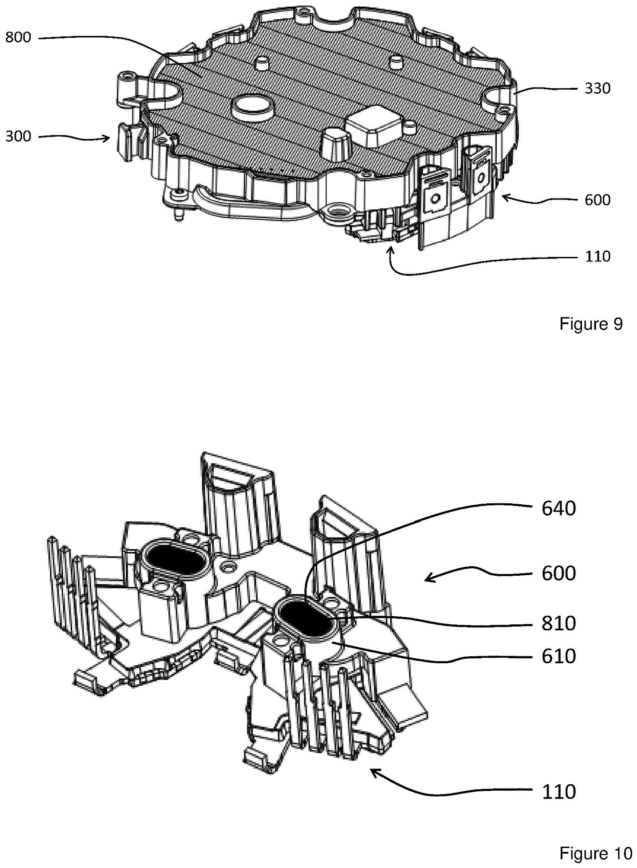

La figure 9 représente une troisième étape d'assemblage au cours de laquelle le moyen de protection 800 est versé dans le logement 390 du support 300 sur le module électronique de commande 700. Le moyen de protection coule dans des interstices entre le support 300 et le module électronique de commande 700. Le moyen de protection 800 coule ainsi sous le module de commande 700 jusqu'à l'ouverture 310 du support puis dans la cavité 640 du boitier de mesure 600.

Un écoulement entre la première extrémité libre 630 et la gorge 370 est empêché par le joint 350.

La figure 10, la figure 11 et la figure 12 représentent des étapes d'assemblage du système électronique 104 selon le deuxième mode de réalisation.

La figure 10 représente une première étape d'assemblage dans laquelle on coule la résine 810 dans la cavité 640 du boitier de mesure 600.

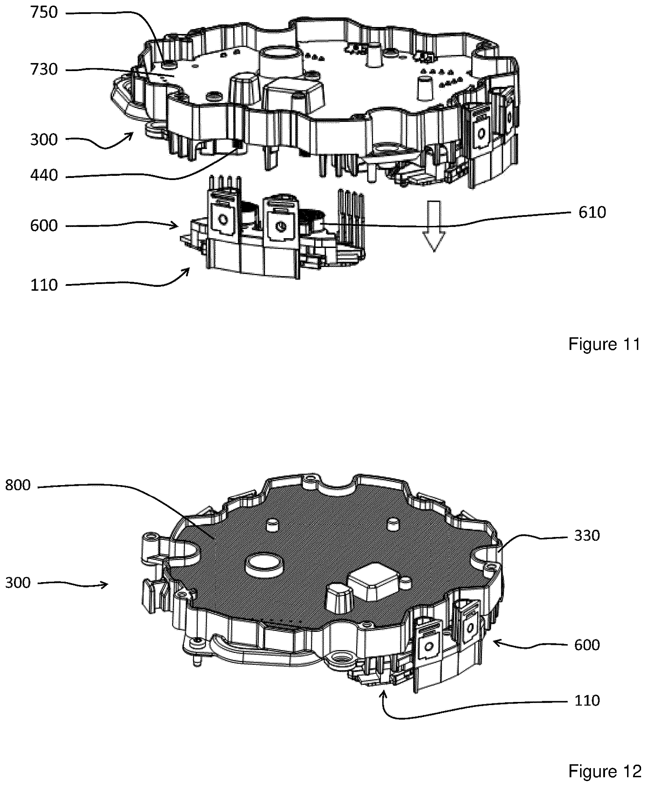

La figure 11 représente une deuxième étape d'assemblage au cours de laquelle on assemble le boitier de mesure 600 et le support 300, le module électronique de commande 700 ayant été monté dans le logement 390 du support 300.

La première excroissance tubulaire 380 pénètre dans la résine 810.

La résine 810 polymérise. Par exemple la résine 810 polymérise sous l'effet d'un apport de chaleur extérieur ou la résine 810 est une résine auto-polymérisante, c'est-à-dire une résine apte à polymériser à température ambiante.

A la fin de cette étape la résine 810 forme une étanchéité entre la première excroissance tubulaire 380 et la deuxième excroissance tubulaire 680. Le capteur à effet Hall 460 est entouré par la résine 810.

La figure 12 représente une troisième étape d'assemblage au cours de laquelle le moyen de protection 820 est versé dans le logement 390 du support 300 sur le module électronique de commande 700. Le moyen de protection 820 coule dans des interstices entre le support 300 et le module électronique de commande 700. Le moyen de protection 820 coule ainsi sous le module de commande 700 jusqu'à l'ouverture 310 du support. L'écoulement du moyen de protection 820 dans la cavité 640 est bloqué par la résine 810.

## Revendications

1. Système électronique (104) comprenant :
a. un module électronique de puissance (110) permettant la conversion d'un courant continu à un courant alternatif, le module électronique de puissance (110) comprenant :
i. une première barre omnibus (206) et une deuxième barre omnibus (208) permettant une alimentation du module électronique de puissance (110) avec le courant continu,
ii. une troisième barre omnibus (522) apte à alimenter un bobinage de phase d'une machine électrique tournante (130),
iii. une broche de commande (520) recevant un signal de commande permettant de piloter le module électronique de puissance (110),
b. un module électronique de commande (700) distinct du module électronique de puissance (110) et configuré pour générer le signal de commande, le module électronique de commande (700) comprenant un dispositif électronique de mesure (440),
c. un support (300) comprenant une ouverture (310) et portant le module électronique de commande (700) sur un premier côté (320) du support, le support (300) étant en métal,
d. un boitier de mesure (600) comprenant une cavité (640), le boitier de mesure (600) étant situé d'un deuxième côté (360) du support opposé au premier côté (320) du support,
le dispositif électronique de mesure (440) pénétrant dans l'ouverture (310) du support (300) et dans la cavité (640) du boitier de mesure (600),
un moyen d'étanchéité (350, 810) assurant une étanchéité entre le boitier de mesure (600) et le support (300).

2. Système électronique (104) selon la revendication précédente dans lequel le module électronique de puissance comprend une première boite surmoulée sur la première barre omnibus, la deuxième barre omnibus, la troisième barre omnibus et la broche de commande, et dans lequel le boitier de mesure (600) est formé en continuité de matière avec la première boite surmoulée du module électronique de puissance (110).

3. Système électronique (104) selon l'une des revendications précédentes dans lequel le boitier de mesure (600) comprend une cheminée (610), comprenant une première extrémité libre (630), entourant une extrémité ouverte de la cavité (640) et le support (300) comprend une gorge (370) en regard de la première extrémité libre (630) de la cheminée (610) du boitier de mesure (600).

4. Système électronique (104) selon l'une des revendications 1 à 2 dans lequel le support (300) comprend une cheminée, comprenant une première extrémité libre, entourant l'ouverture du support du deuxième côté (360) du support et le boitier de mesure comprend une gorge en regard de la première extrémité libre de la cheminée.

5. Système électronique (104) selon l'une des revendications 3 et 4 dans lequel un joint inséré (350) dans la gorge (370) assure l'étanchéité entre le boitier de mesure (600) et le support (300).

6. Système électronique (104) selon la revendication précédente dans lequel le joint (350) est un dépôt de colle.

7. Système électronique (104) selon l'une des revendications 1 à 2 dans lequel :
a. soit le boitier de mesure (600) comprend une cheminée (610), comprenant une première extrémité libre d'une première forme, entourant une extrémité ouverte de la cavité (640) et le support (300) comprend une surface d'appui d'une deuxième forme, complémentaire de la première forme en regard de la première extrémité libre de la cheminée (610) du boitier de mesure (600),
b. soit le support (300) comprend une cheminée, comprenant une première extrémité libre d'une première forme, entourant l'ouverture du support du deuxième côté (360) du support et le boitier de mesure (600) comprend une face d'appui d'une deuxième forme, complémentaire de la première forme en regard de la première extrémité libre de la cheminée du support (300),
c. soit le support (300) comprend une première cheminée, comprenant une première extrémité libre d'une première forme, entourant l'ouverture du support du deuxième côté du support et le boitier de mesure (600) comprend une deuxième cheminée, comprenant une deuxième extrémité libre d'une deuxième forme complémentaire de la première forme, entourant une extrémité ouverte de la cavité (640), la deuxième extrémité libre de la deuxième cheminée du boitier de mesure (600) étant en regard de la première extrémité libre de la première cheminée du support (300),
un joint étant disposé entre la première forme du support (300) et la deuxième forme du boitier de mesure (600).

8. Système électronique selon l'une des revendications 1 et 2 dans lequel le support (300) comprend une première excroissance tubulaire (380) entourant l'ouverture (310) du support (300) du deuxième côté (360) du support (300) et le boitier de mesure (600) comprend une deuxième excroissance tubulaire (680) au moins partiellement autour de la cavité (640), la première excroissance tubulaire (380) pénétrant dans la deuxième excroissance tubulaire (680).

9. Système électronique (104) selon la revendication précédente dans lequel un dispositif d'étanchéité est disposé entre la première excroissance tubulaire et la deuxième excroissance tubulaire.

10. Système électronique (104) selon la revendication précédente dans lequel le dispositif d'étanchéité est une résine (810) versée dans la cavité puis polymérisée.

11. Système électronique (104) selon l'une des revendications précédentes dans lequel le boitier de mesure (600) comprend un tore magnétique (430) présentant un entrefer (450) et le dispositif électronique de mesure (440) comprend un capteur à effet hall (460) inséré dans la cavité (640) du boitier de mesure (600) et l'entrefer (450), le tore magnétique (430) et le capteur à effet hall (460) coopérant pour mesurer le courant d'un conducteur électrique (622) traversant le tore magnétique (430).

12. Système électronique (104) selon la revendication précédente dans lequel le conducteur électrique (622) est connecté électriquement à la troisième barre omnibus (522).

13. Système électronique (104) selon l'une des revendications 11 et 12 dans lequel le boitier de mesure (600) est surmoulé sur le conducteur électrique (622) et/ou le boitier de mesure (600) est surmoulé sur le tore magnétique (430).

14. Système électronique (104) selon l'une des revendications précédentes dans lequel le support (300) défini un logement avec une paroi de fond (340) dans laquelle est ménagée l'ouverture (310), le module électronique de commande (700) est logé dans le logement et un gel (800) ou une résine de protection remplit le logement de manière à recouvrir le module électronique de commande (700).

15. Ensemble électrique (100) comprenant :
a. un système électronique (104) selon l'une des revendications précédente,
b. une machine électrique tournante (130)

## Patentansprüche

1. Elektronisches System (104), das Folgendes beinhaltet:
a. ein elektronisches Leistungsmodul (110), das die Umwandlung eines Gleichstroms in einen Wechselstrom ermöglicht, wobei das elektronische Leistungsmodul (110) Folgendes beinhaltet:
i. eine erste Sammelschiene (206) und eine zweite Sammelschiene (208), die eine Versorgung des elektronischen Leistungsmoduls (110) mit dem Gleichstrom ermöglichen,
ii. eine dritte Sammelschiene (522), die dazu fähig ist, eine Phasenwicklung einer umlaufenden elektrischen Maschine (130) zu versorgen,
iii. einen Steuerstift (520), der ein Steuersignal empfängt, das die Ansteuerung des elektronischen Leistungsmoduls (110) ermöglicht,
b. ein elektronisches Steuermodul (700), das von dem elektronischen Leistungsmodul (110) getrennt ist und dazu konfiguriert ist, das Steuersignal zu erzeugen, wobei das elektronische Steuermodul (700) eine elektronische Messvorrichtung (440) beinhaltet,
c. einen Träger (300), der eine Öffnung (310) beinhaltet und das elektronische Steuermodul (700) auf einer ersten Seite (320) des Trägers trägt, wobei der Träger (300) aus Metall ist,
d. ein Messgehäuse (600), das einen Hohlraum (640) beinhaltet, wobei sich das Messgehäuse (600) auf einer zweiten Seite (360) des Trägers, die zu der ersten Seite (320) des Trägers entgegengesetzt ist, befindet,
wobei die elektronische Messvorrichtung (440) in die Öffnung (310) des Trägers (300) und in den Hohlraum (640) des Messgehäuses (600) hineinragt,
wobei ein Dichtungsmittel (350, 810) eine Dichtheit zwischen dem Messgehäuse (600) und dem Träger (300) sicherstellt.

2. Elektronisches System (104) nach dem vorhergehenden Anspruch, wobei das elektronische Leistungsmodul einen ersten Kasten beinhaltet, der auf die erste Sammelschiene, die zweite Sammelschiene, die dritte Sammelschiene und den Steuerstift aufgeformt ist, und wobei das Messgehäuse (600) mit dem ersten aufgeformten Kasten des elektronischen Leistungsmoduls (110) einstückig ausgebildet ist.

3. Elektronisches System (104) nach einem der vorhergehenden Ansprüche, wobei das Messgehäuse (600) einen Schacht (610) beinhaltet, der ein erstes freies Ende (630) beinhaltet und ein offenes Ende des Hohlraums (640) umgibt, und der Träger (300) eine Vertiefung (370) gegenüber dem ersten freien Ende (630) des Schachts (610) des Messgehäuses (600) beinhaltet.

4. Elektronisches System (104) nach einem der Ansprüche 1 bis 2, wobei der Träger (300) einen Schacht beinhaltet, der ein erstes freies Ende beinhaltet und die Öffnung des Trägers auf der zweiten Seite (360) des Trägers umgibt, und das Messgehäuse eine Vertiefung gegenüber dem ersten freien Ende des Schachts beinhaltet.

5. Elektronisches System (104) nach einem der Ansprüche 3 und 4, wobei eine in die Vertiefung (370) eingefügte Abdichtung (350) die Dichtheit zwischen dem Messgehäuse (600) und dem Träger (300) sicherstellt.

6. Elektronisches System (104) nach dem vorhergehenden Anspruch, wobei die Abdichtung (350) eine Klebstoffablagerung ist.

7. Elektronisches System (104) nach einem der Ansprüche 1 bis 2, wobei:
a. entweder das Messgehäuse (600) einen Schacht (610) beinhaltet, der ein erstes freies Ende mit einer ersten Form beinhaltet und ein offenes Ende des Hohlraums (640) umgibt, und der Träger (300) eine Anlagefläche mit einer zweiten Form, die zu der ersten Form komplementär ist, gegenüber dem ersten freien Ende des Schachts (610) des Messgehäuses (600) beinhaltet,
b. oder der Träger (300) einen Schacht beinhaltet, der ein erstes freies Ende mit einer ersten Form beinhaltet und die Öffnung des Trägers auf der zweiten Seite (360) des Trägers umgibt, und das Messgehäuse (600) eine Anlagefläche mit einer zweiten Form, die zu der ersten Form komplementär ist, gegenüber dem ersten freien Ende des Schachts des Trägers (300) beinhaltet,
c. oder der Träger (300) einen ersten Schacht beinhaltet, der ein erstes freies Ende mit einer ersten Form beinhaltet und die Öffnung des Trägers auf der zweiten Seite des Trägers umgibt, und das Messgehäuse (600) einen zweiten Schacht beinhaltet, der ein zweites freies Ende mit einer zweiten Form, die zu der ersten Form komplementär ist, beinhaltet und ein offenes Ende des Hohlraums (640) umgibt, wobei das zweite freie Ende des zweiten Schachts des Messgehäuses (600) gegenüber dem ersten freien Ende des ersten Schachts des Trägers (300) liegt,
wobei zwischen der ersten Form des Trägers (300) und der zweiten Form des Messgehäuses (600) eine Abdichtung angeordnet ist.

8. Elektronisches System nach einem der Ansprüche 1 und 2, wobei der Träger (300) einen ersten röhrenförmigen Ansatz (380) beinhaltet, der die Öffnung (310) des Trägers (300) auf der zweiten Seite (360) des Trägers (300) umgibt, und das Messgehäuse (600) einen zweiten röhrenförmigen Ansatz (680) mindestens teilweise um den Hohlraum (640) herum beinhaltet, wobei der erste röhrenförmige Ansatz (380) in den zweiten röhrenförmigen Ansatz (680) hineinragt.

9. Elektronisches System (104) nach dem vorhergehenden Anspruch, wobei zwischen dem ersten röhrenförmigen Ansatz und dem zweiten röhrenförmigen Ansatz eine Dichtungsvorrichtung angeordnet ist.

10. Elektronisches System (104) nach dem vorhergehenden Anspruch, wobei die Dichtungsvorrichtung ein Harz (810) ist, das in den Hohlraum gegossen wird und dann polymerisiert.

11. Elektronisches System (104) nach einem der vorhergehenden Ansprüche, wobei das Messgehäuse (600) einen Magnetkern (430) beinhaltet, der einen Luftspalt (450) aufweist, und die elektronische Messvorrichtung (440) einen Hall-Effekt-Sensor (460) beinhaltet, der in dem Hohlraum (640) des Messgehäuses (600) und dem Luftspalt (450) eingefügt ist, wobei der Magnetkern (430) und der Hall-Effekt-Sensor (460) zusammenwirken, um den Strom eines elektrischen Leiters (622), der den Magnetkern (430) durchquert, zu messen.

12. Elektronisches System (104) nach dem vorhergehenden Anspruch, wobei der elektrische Leiter (622) mit der dritten Sammelschiene (522) elektrisch verbunden ist.

13. Elektronisches System (104) nach einem der Ansprüche 11 und 12, wobei das Messgehäuse (600) auf den elektrischen Leiter (622) aufgeformt ist und/oder das Messgehäuse (600) auf den Magnetkern (430) aufgeformt ist.

14. Elektronisches System (104) nach einem der vorhergehenden Ansprüche, wobei der Träger (300) eine Aufnahme mit einer Bodenwand (340), in der die Öffnung (310) eingerichtet ist, definiert, wobei das elektronische Steuermodul (700) in der Aufnahme aufgenommen ist und ein Gel (800) oder ein Schutzharz die Aufnahme so ausfüllt, dass es das elektronische Steuermodul (700) abdeckt.

15. Elektrische Einheit (100), die Folgendes beinhaltet:
a. ein elektronisches System (104) nach einem der vorhergehenden Ansprüche,
b. eine umlaufende elektrische Maschine (130).

## Claims

1. Electronic system (104) comprising:
a. a power electronics module (110) making it possible to convert a DC current to an AC current, the power electronics module (110) comprising:
i. a first busbar (206) and a second busbar (208) for supplying the power electronics module (110) with the DC current,
ii. a third busbar (522) able to supply a phase winding of a rotating electric machine (130),
iii. a control pin (520) receiving a control signal for driving the power electronics module (110),
b. an electronic control module (700) separate from the power electronics module (110) and configured so as to generate the control signal, the electronic control module (700) comprising an electronic measuring device (440),
c. a support (300) comprising an opening (310) and carrying the electronic control module (700) on a first side (320) of the support, the support (300) being made of metal,
d. a measurement housing (600) comprising a cavity (640), the measurement housing (600) being located on a second side (360) of the support opposite the first side (320) of the support,
the electronic measuring device (440) penetrating into the opening (310) in the support (300) and into the cavity (640) in the measurement housing (600),
a sealing means (350, 810) providing a seal between the measurement housing (600) and the support (300).

2. Electronic system (104) according to the preceding claim, wherein the power electronics module comprises a first casing overmolded onto the first busbar, the second busbar, the third busbar and the control pin, and wherein the measurement housing (600) is formed contiguously with the first overmolded casing of the power electronics module (110).

3. Electronic system (104) according to either of the preceding claims, wherein the measurement housing (600) comprises a chimney (610), comprising a first free end (630), surrounding an open end of the cavity (640), and the support (300) comprises a groove (370) facing the first free end (630) of the chimney (610) of the measurement housing (600).

4. Electronic system (104) according to either of Claims 1 and 2, wherein the support (300) comprises a chimney, comprising a first free end, surrounding the opening in the support on the second side (360) of the support, and the measurement housing comprises a groove facing the first free end of the chimney.

5. Electronic system (104) according to either of Claims 3 and 4, wherein a seal (350) inserted in the groove (370) provides the seal between the measurement housing (600) and the support (300).

6. Electronic system (104) according to the preceding claim, wherein the seal (350) is an adhesive deposit.

7. Electronic system (104) according to either of Claims 1 and 2, wherein:
a. either the measurement housing (600) comprises a chimney (610), comprising a first free end of a first shape, surrounding an open end of the cavity (640), and the support (300) comprises a bearing surface of a second shape, complementary to the first shape, facing the first free end of the chimney (610) of the measurement housing (600),
b. or the support (300) comprises a chimney, comprising a first free end of a first shape, surrounding the opening in the support on the second side (360) of the support, and the measurement housing (600) comprises a bearing face of a second shape, complementary to the first shape, facing the first free end of the chimney of the support (300),
c. or the support (300) comprises a first chimney, comprising a first free end of a first shape, surrounding the opening in the support on the second side of the support, and the measurement housing (600) comprises a second chimney, comprising a second free end of a second shape complementary to the first shape, surrounding an open end of the cavity (640), the second free end of the second chimney of the measurement housing (600) facing the first free end of the first chimney of the support (300),
a seal being arranged between the first shape of the support (300) and the second shape of the measurement housing (600).

8. Electronic system according to either of Claims 1 and 2, wherein the support (300) comprises a first tubular protuberance (380) surrounding the opening (310) in the support (300) on the second side (360) of the support (300), and the measurement housing (600) comprises a second tubular protuberance (680) at least partially around the cavity (640), the first tubular protuberance (380) penetrating into the second tubular protuberance (680).

9. Electronic system (104) according to the preceding claim, wherein a sealing device is arranged between the first tubular protuberance and the second tubular protuberance.

10. Electronic system (104) according to the preceding claim, wherein the sealing device is a resin (810) that is poured into the cavity and then polymerized.

11. Electronic system (104) according to one of the preceding claims, wherein the measurement housing (600) comprises a magnetic toroid (430) having an air gap (450), and the electronic measuring device (440) comprises a Hall effect sensor (460) inserted in the cavity (640) in the measurement housing (600) and the air gap (450), the magnetic toroid (430) and the Hall effect sensor (460) interacting so as to measure the current of an electrical conductor (622) passing through the magnetic toroid (430).

12. Electronic system (104) according to the preceding claim, wherein the electrical conductor (622) is electrically connected to the third busbar (522).

13. Electronic system (104) according to either of Claims 11 and 12, wherein the measurement housing (600) is overmolded onto the electrical conductor (622) and/or the measurement housing (600) is overmolded onto the magnetic toroid (430).

14. Electronic system (104) according to one of the preceding claims, wherein the support (300) defines a receptacle with a bottom wall (340) in which the opening (310) is formed, the electronic control module (700) is housed in the receptacle and a gel (800) or a protective resin fills the receptacle so to cover the electronic control module (700).

15. Electrical assembly (100) comprising:
a. an electronic system (104) according to one of the preceding claims,
b. a rotating electric machine (130).
